Europäisches Patentamt

European Patent Office

Office européen des brevets

(19)

(11) Numéro de publication : **0 071 504**
**B1**

(12) **FASCICULE DE BREVET EUROPÉEN**

(45) Date de publication du fascicule du brevet :
**24.04.85**

(21) Numéro de dépôt : **82401303.1**

(22) Date de dépôt : **09.07.82**

(51) Int. Cl.⁴ : **G 01 R 25/00, H 04 N 5/95**

(54) **Dispositif de mesure de l'angle de phase entre un signal sinusoïdal et un signal logique périodique de même fréquence.**

(30) Priorité : **24.07.81 FR 8114420**

(43) Date de publication de la demande :
**09.02.83 Bulletin 83/06**

(45) Mention de la délivrance du brevet :
**24.04.85 Bulletin 85/17**

(84) Etats contractants désignés :
**BE DE GB NL**

(56) Documents cités :
**FR-A- 2 008 842**
**FR-A- 2 086 722**
**FR-A- 2 124 505**
**US-A- 3 602 812**
**US-A- 4 075 698**

(73) Titulaire : **THOMSON-CSF**
**173, Boulevard Haussmann**
**F-75379 Paris Cedex 08 (FR)**

(72) Inventeur : **Porrot, Pascal**
**THOMSON-CSF SCPI 173, bld Haussmann**
**F-75379 Paris Cedex 08 (FR)**
Inventeur : **Rougeolle, Daniel**
**THOMSON-CSF SCPI 173, bld Haussmann**
**F-75379 Paris Cedex 08 (FR)**

(74) Mandataire : **Turlèque, Clotilde et al**
**THOMSON-CSF SCPI 173, Bld Haussmann**
**F-75379 Paris Cedex 08 (FR)**

Jouve, 18, rue St-Denis, 75001 Paris, France

## Description

L'invention concerne un dispositif de mesure de l'angle de phase entre un signal sinusoïdal et un signal logique périodique de même fréquence que le signal sinusoïdal. Elle s'applique aux systèmes synchroniseurs et plus particulièrement aux systèmes de contrôle de la synchronisation des lignes de télévision dans les magnétoscopes.

Dans les dispositifs connus, la mesure de l'angle de phase, c'est-à-dire la mesure de l'angle de décalage entre deux ondes de même fréquence, se fait selon des procédés dits analogiques moins précis que le dispositif selon l'invention, basé sur un procédé dit numérique. A titre d'exemple, le dispositif selon l'invention atteint une précision dans la mesure de l'angle de phase telle qu'une horloge supérieure à 1 GHz serait nécessaire à un dispositif connu pour obtenir la même précision. De tels systèmes de mesure ne sont pas actuellement répandus de façon courante. Au contraire, le fait de numériser les mesures sur le signal sinusoïdal permet d'obtenir assez facilement une très haute précision, dans le dispositif de l'invention.

Dans son fondement, le dispositif selon l'invention convertit le signal sinusoïdal à fréquence F en signal numérique au moyen d'un convertisseur analogique-numérique échantillonné par le signal logique — celui avec lequel il faut mesurer l'angle de phase- ledit signal logique étant de fréquence d'échantillonnage égale à 4 fois celle du signal sinusoïdal F. Deux échantillons sont mesurés sur chaque demi-période sinusoïdale : le premier échantillon donne une valeur représentative du sinus de l'angle de phase $\phi$, et le deuxième échantillon donne une valeur représentative du cosinus de l'angle de phase $\phi$, décalé de $\pi/2$, à partir desquels il est facile de calculer l'angle $\phi$.

L'une des originalités du dispositif selon l'invention réside dans le fait que la mesure de l'angle $\phi$ est indépendante de l'amplitude du signal sinusoïdal, car le dispositif mesure soit la tangente, soit la cotangente de l'angle $\phi$ en valeur absolue, éliminant ainsi l'amplitude A du signal sinusoïdal. Le calcul de la tangente ou de la cotangente de l'angle $\phi$, en faisant le rapport du sinus sur le cosinus ou inversement, conduit en fait à ne prendre en compte que les parties dans lesquelles on peut considérer que la tangente ou la cotangente sont des fonctions linéaires : c'est pourquoi le dispositif selon l'invention mesure les valeurs absolues du sinus et du cosinus de l'angle, et selon le rapport obtenu, il calcule soit la tangente, soit la cotangente, de façon à ne travailler que dans les parties linéaires de ces fonctions. Un autre aspect original du dispositif réside dans le fait que la précision obtenue dépend uniquement du nombre de bits du convertisseur analogique numérique.

De façon plus précise, l'invention concerne un dispositif de mesure de l'angle de phase entre un signal sinusoïdal et un signal logique périodique, de même fréquence, comportant sur l'entrée du signal sinusoïdal, un convertisseur analogique-numérique échantillonneur, caractérisé en ce qu'il comprend :

— un circuit multiplicateur de fréquence qui transforme le signal logique périodique de fréquence F en un signal logique périodique de fréquence 4 F, servant à échantillonner le convertisseur A-F à raison de deux échantillons par demi période du signal sinusoïdal, ces échantillons étant représentatifs de sin $\phi$ et de cos $\phi$ décalé de $\pi/2$ ;

— un circuit d'extraction à partir des échantillons fournis par le convertisseur A-N, des valeurs absolues de A sin $\phi$ et A cos $\phi$, A étant l'amplitude du signal sinusoïdal, ainsi que les signes de sin $\phi$ et de cos $\phi$ ;

— un circuit de calcul de la valeur absolue de tg $\phi$ ou de cotg $\phi$ à partir des valeurs absolues de A sin $\phi$ et de A cos $\phi$, selon que A sin $\phi$ < A cos $\phi$ ou que A sin $\phi$ > A cos $\phi$, avec élimination de l'amplitude A ;

— un accumulateur qui stocke une pluralité d'informations tg $\phi$ ou cotg $\phi$ et en restitue une valeur moyenne ;

— une mémoire programmable qui reçoit sur ses entrées les informations numériques représentatives de tg$\phi$ ou cotg $\phi$, de l'opération effectuée soit en tg $\phi$ soit en cotg $\phi$, du signe de cos $\phi$ et du signe de sin $\phi$, et qui délivre sur ses sorties une information numérique représentative de l'angle de phase $\phi$.

L'invention sera mieux comprise par la description d'un exemple de réalisation, cette description s'appuyant sur les figures annexées.

La figure 1 est un schéma synoptique du dispositif de mesure de l'angle de phase selon l'invention ;

La figure 2 représente des courbes représentatives du signal sinusoïdal et du signal logique d'échantillonnage ;

Les figures 3 et 4 représentent les zones de travail utile sur les courbes de tangente $\phi$ et cotangente $\phi$ ;

La figure 5 est un schéma d'extraction par un convertisseur analogique-numérique des informations de sinus $\phi$ et cosinus $\phi$.

La figure 6 est un schéma, sous forme de bloc diagramme, du dispositif selon l'invention.

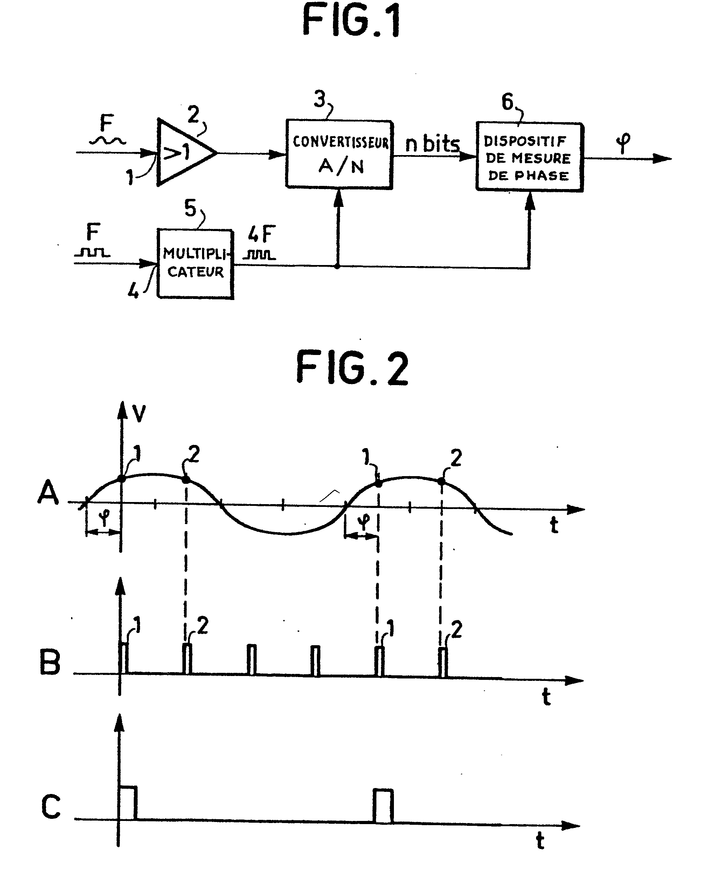

La figure 1 représente le schéma synoptique très simplifié du dispositif de mesure de l'angle de phase selon l'invention.

Un signal sinusoïdal de fréquence F, appliqué sur la borne d'entrée 1 d'un amplificateur 2, est transmis à un convertisseur analogique numérique 3, à n bits de conversion. Parallèlement, un signal logique rectangulaire de même fréquence F que le signal sinusoïdal, est appliqué à la borne d'entrée 4 d'un multiplicateur de fréquence par 4, 5, qui délivre donc un signal logique de fréquence 4 F, fréquence

2

utilisée pour échantillonner le convertisseur analogique numérique 3. Le signal de sortie du convertisseur analogique-numérique, à n bits, est appliqué à un dispositif 6 de mesure de la phase, lui-même piloté par le même signal de fréquence 4 F que celui qui échantillonne le convertisseur 3.

Le dispositif de mesure 6 délivre une information relative à l'angle de phase $\phi$, qui sera détaillée par la suite. La mesure de l'angle de phase $\phi$ réside, dans son fondement, dans la mesure des sinus et cosinus de l'angle $\phi$, ainsi que le montre la figure 2.

Sur la figure 2 sont représentés le signal sinusoïdal sur la courbe A et le signal de référence de même fréquence F sur la courbe C. La courbe B représente le signal d'échantillonnage obtenu à la sortie du multiplicateur 5 figure 1 à la fréquence 4 F. Par conséquent, à une période du signal sinusoïdal correspondent quatre signaux rectangulaires d'échantillonnage, ou encore deux signaux par demi-période : ces deux signaux utilisés à chaque demi-onde sont repérés 1 et 2.

Le déphasage entre le signal sinusoïdal et le signal logique est représenté sur la courbe A par la distance $\phi$, représentant le décalage entre le zéro sinusoïdal et le zéro logique de la courbe C. Le sinus de l'angle $\phi$ de déphasage est mesuré par le nombre de bits obtenus à la sortie du convertisseur analogique numérique, échantillonné par l'impulsion d'indice 1. Le cosinus de cet angle est mesuré, dans les mêmes conditions, par l'échantillon d'indice 2, décalé de $\pi/2$. La mesure du sinus et du cosinus de l'angle de phase $\phi$ permet le calcul du déphasage dans une plage de $\pm \pi$.

Le signal sinusoïdal étant de la forme :

$$v(t) = A \sin(2\pi Ft + \phi)$$

la valeur obtenue correspondant à l'échantillon d'indice 1 représente $A \sin \phi$, et la valeur obtenue correspondant à l'échantillon d'indice 2 représente $A \cos \phi$.

Pour s'affranchir du terme d'amplitude A du signal sinusoïdal, il suffit d'effectuer le rapport $A \sin \phi / A \cos \phi$, qui donne $tg\phi$, ou bien le rapport $A \cos \phi / A \sin \phi$, qui donne $cotg \phi$.

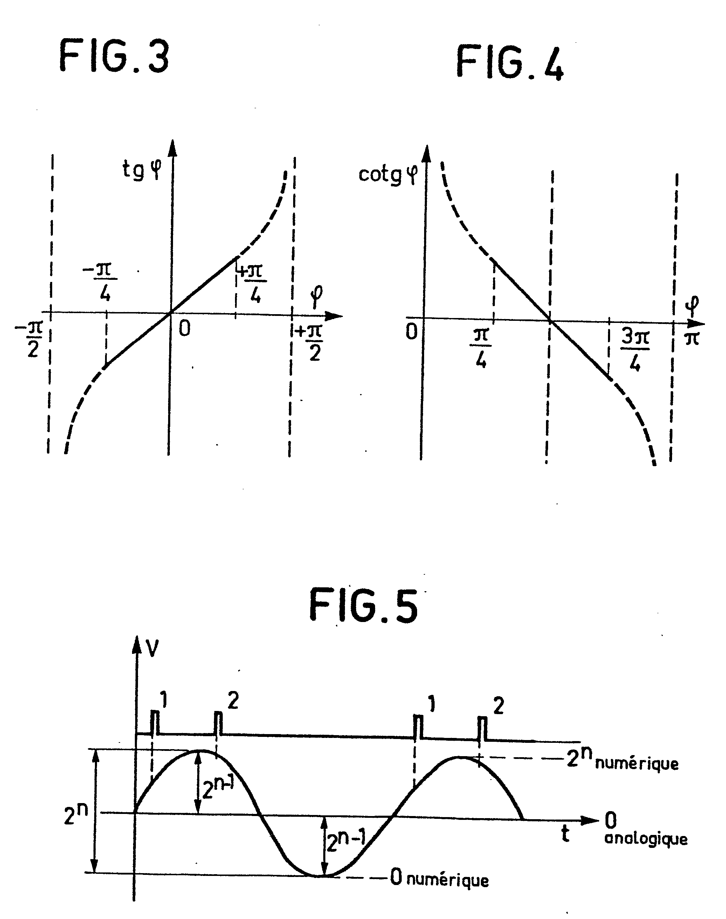

En fait, comme le montrent les figures 3 et 4, seule une partie des courbes représentatives de $tg \phi$ et $cotg \phi$ sont utilisables pour la mesure de l'angle $\phi$, avec précision.

Sur la figure 3 qui représente la courbe de $tg \phi$ en fonction de l'angle on rappelle que seule la partie de cette courbe correspondant à une plage comprise entre $- \pi/4$ et $+ \pi/4$ peut être assimilé à une droite. Sur la figure 4, qui représente $cotg \phi$ en fonction de l'angle $\phi$, on rappelle de la même façon que seule une plage comprise entre $\pi/4$ et $3 \pi/4$ peut être assimilée à une droite. Ces zones correspondant à des plages de $\pi/2$, sur la plage de mesure du dispositif qui est de $+$ ou $- \pi$, le dispositif calculera, selon l'angle de phase, soit une tangente soit une cotangente.

Ainsi, pour un angle de phase compris entre $\pi$ et $- (3\pi/4)$, $-(\pi/4)$ et $\pi/4$ et $3\pi/4$ et $+ \pi$ le dispositif calcule : $tg \phi$ et pour un angle de phase compris entre $- (3\pi/4)$ et $- (\pi/4)$, et entre $+ (\pi/4)$ et $3\pi/4$, le dispositif calcule : $cotg \phi$.

La décision de calculer soit la tangente soit la cotangente est prise par un comparateur qui compare les valeurs absolues de $A \sin \phi$ et $A \cos \phi$ : si la valeur absolue $|A \sin \phi| < |A \cos \phi|$, le dispositif calcule la tangente de l'angle $\phi$.

Les valeurs de $tg \phi$ ou $cotg \phi$ sont calculées en valeurs absolues, à partir des valeurs absolues de $A \sin \phi$ et $A \cos \phi$, sur une plage $\Delta \phi$ de $+\pi/4$, ce qui découpe le système de mesure en 8 zones.

| Angles | 0 | $\pi/4$ | $\pi/2$ | $3\pi/4$ | $\pi$ | $5\pi/4$ | $3\pi/2$ | $7\pi/4$ | $2\pi$ | |
|---|---|---|---|---|---|---|---|---|---|---|
| Zones | 1 | 2 | 3 | 4 | 5 | 6 | 7 | 8 | | |
| Signes sinus | + | + | + | + | - | - | - | - | | |
| Signes cosinus | + | + | - | - | - | - | + | + | | |
| Calcul de tg | oui | | | oui | oui | | | oui | | |
| Calcul de cotg | | oui | oui | | | oui | oui | | | |

La connaissance des valeurs absolues de $tg \phi$ ou de $cotg \phi$, selon la zone ou le quadrant correspondant à l'angle de déphasage $\phi$, ainsi que celles des signes de $\sin \phi$ et $\cos \phi$ permet de déterminer sans équivoque l'angle $\phi$ dans une plage de $\pm \pi$.

Les figures suivantes permettront de mieux comprendre comment sont mesurés les signes et les valeurs absolues des sinus et cosinus, tangente et cotangente.

La figure 5 représente le schéma d'extraction par un calculateur analogique numérique des informations représentatives de $\sin \phi$ et $\cos \phi$.

Au-dessus de la courbe représentant un peu plus qu'une période du signal sinusoïdal, a été rapporté le signal logique d'échantillonnage, avec un certain déphasage par rapport au signal sinusoïdal. Le signal sinusoïdal est décomposé en $2^n$ niveaux ou valeurs numériques, compris entre 0 et $2^n$, le zéro

3

analogique étant au niveau de $2^{n-1}$, et l'amplitude du signal étant comprise à l'intérieur des $2^n$ niveaux numériques.

Ainsi, une demi-onde négative est mesurée sur $2^{n-1}$ niveaux au maximum et une demi onde positive mesurée sur $2^{n-1}$ niveaux au maximum. En utilisant un convertisseur 9 bits, soit $2^9 = 512$ niveaux, le zéro de la sinusoïde se situe à la valeur 256, tandis que la crête négative se situe au niveau 0 et la crête positive au niveau 511. Les 9 bits du convertisseur sont utilisés en deux groupes : le bit de plus fort poids $2^8$ est représentatif du signe de l'échantillon, et les autres bits, de $2^0$ à $2^7$ sont représentatifs de la valeur numérique de l'échantillon. Le signal sinusoïdal est donc découpé par un convertisseur analogique-numérique à 9 bits en valeurs numériques rapportées dans le tableau ci-dessous, et en valeur absolue.

| valeurs numériques | Bits de signe $2^8$ | Sorties du convertisseur (bits représentatifs de la valeur analogique) | | | | | | | |
|---|---|---|---|---|---|---|---|---|---|
| | | $2^7$ | $2^6$ | $2^5$ | $2^4$ | $2^3$ | $2^2$ | $2^1$ | $2^0$ |
| 511 | 1 | 1 | 1 | 1 | 1 | 1 | 1 | 1 | 1 |
| 510 | 1 | 1 | 1 | 1 | 1 | 1 | 1 | 1 | 0 |
| ... | ... | | | | | | | | |
| 258 | 1 | 0 | 0 | 0 | 0 | 0 | 0 | 1 | 0 |
| 257 | 1 | 0 | 0 | 0 | 0 | 0 | 0 | 0 | 1 |
| 256 (valeur analogique) | 1 | 0 | 0 | 0 | 0 | 0 | 0 | 0 | 0 |
| 255 | 0 | 1 | 1 | 1 | 1 | 1 | 1 | 1 | 1 |
| 254 | 0 | 1 | 1 | 1 | 1 | 1 | 1 | 1 | 0 |
| ... | ... | | | | | | | | |
| 1 | 0 | 0 | 0 | 0 | 0 | 0 | 0 | 0 | 1 |
| 0 | 0 | 0 | 0 | 0 | 0 | 0 | 0 | 0 | 0 |

Deux cas se présentent :

Pour les mesures sur des échantillons de valeurs numériques supérieures ou égales à 256, c'est-à-dire pour les mesures sur les demi-périodes positives du signal sinusoïdal, pour lesquelles le bit de signe est égal à 1, les bits $2^0$ à $2^7$ sont directement représentatifs de la valeur analogique. Ainsi, sur le tableau précédent, les lignes supérieures à celles du zéro analogique pour lesquelles le bit de signe est égal à 1, représentent directement la valeur analogique d'une demi-période positive du signal sinusoïdal.

Pour les mesures sur des échantillons de valeurs numériques inférieures à 256, qui correspondent aux demi-périodes négatives du signal sinusoïdal, et pour lesquelles le bit de signe est égal à 0, les bits $2^0$ à $2^7$ ne sont plus directement représentatifs de la valeur analogique : en effet, ces derniers sont en complément à 2. Dans ce second cas, pour obtenir des valeurs numériques comprises entre 0 et 256, c'est-à-dire de 0 à 256 = 1 bit de signe $2^8 = 0$, il faut effectuer l'opération complément à 2, ce qui donne la nouvelle représentation numérique ci-dessous.

| Valeurs numériques | Bits de signe $2^8$ | Sorties du convertisseur (bits représentatifs de la valeur analogique) | | | | | | | |
|---|---|---|---|---|---|---|---|---|---|
| | | $2^7$ | $2^6$ | $2^5$ | $2^4$ | $2^3$ | $2^2$ | $2^1$ | $2^0$ |
| 511 | 1 | 1 | 1 | 1 | 1 | 1 | 1 | 1 | 1 |
| 510 | 1 | 1 | 1 | 1 | 1 | 1 | 1 | 1 | 0 |
| ... | ... | | | | | | | | |
| 258 | 1 | 0 | 0 | 0 | 0 | 0 | 0 | 1 | 0 |
| 257 | 1 | 0 | 0 | 0 | 0 | 0 | 0 | 0 | 1 |

| Valeurs numériques | Bits de signe $2^8$ | Sorties du convertisseur (bits représentatifs de la valeur analogique) | | | | | | | |
|---|---|---|---|---|---|---|---|---|---|
| | | $2^7$ | $2^6$ | $2^5$ | $2^4$ | $2^3$ | $2^2$ | $2^1$ | $2^0$ |
| 256 (zéro analogique | 1 | 0 | 0 | 0 | 0 | 0 | 0 | 0 | 0 |
| 255 | 0 | 0 | 0 | 0 | 0 | 0 | 0 | 0 | 1 |
| 254 | 0 | 0 | 0 | 0 | 0 | 0 | 0 | 1 | 0 |
| ... | ... | .............................................................................. | | | | | | | |
| 1 | 0 | 1 | 1 | 1 | 1 | 1 | 1 | 1 | 1 |
| 0 | 0 | 1 | 1 | 1 | 1 | 1 | 1 | 1 | 1 |

L'opération complément à 2 des bits $2^0$ à $2^7$ est donc pilotée par le bit de signe $2^8$.

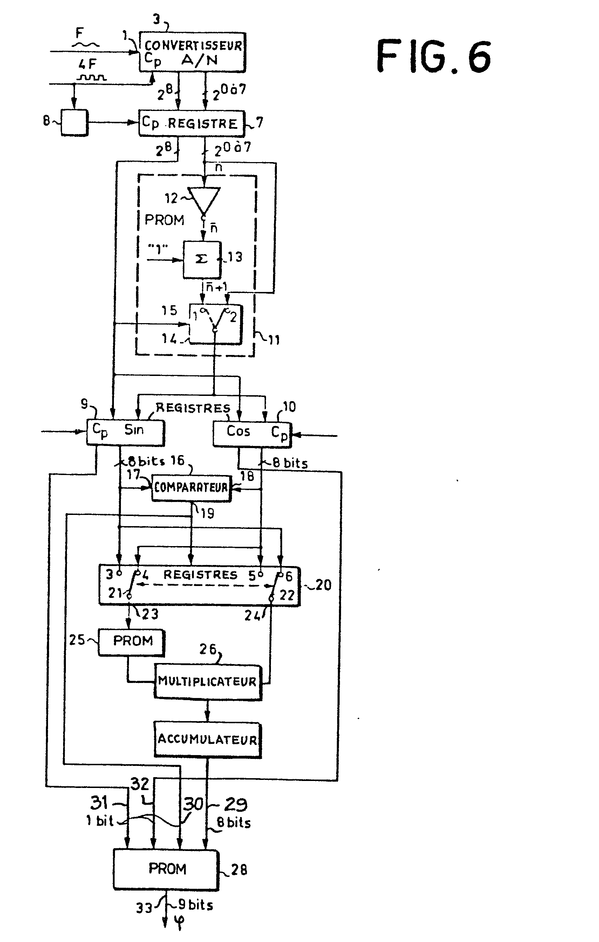

La figure 6 représente le schéma du dispositif suivant l'invention.

Sur cette figure 6, le signal sinusoïdal de fréquence F est appliqué, comme il a été dit précédemment, sur la borne d'entrée 1 d'un convertisseur analogique numérique 3. Celui-ci est piloté par un signal numérique de fréquence 4 F adressé sur sa porte d'horloge $C_p$. Les niveaux de sortie du convertisseur numérique, c'est-à-dire le bit de signe $2^8$ et les bits de valeurs $2^0$ à $2^7$, sont appliqués à un registre 7, lequel est piloté par un circuit 8 qui, à partir du signal logique de fréquence 4 F, extrait les signaux d'horloge correspondant aux échantillons d'indices 1 et 2 sur la figure 2.

Aux bornes de sortie du registre 7, le bit de signe $2^8$ est directement appliqué aux entrées correspondantes de deux autres registres 9 et 10. Les bits de valeurs numériques $2^0$ à $2^7$, c'est-à-dire n valeurs numériques, sont par ailleurs appliqués à un circuit de complément à 2, compris sur la figure 6 à l'intérieur de la ligne pointillée repérée 11. Ce circuit de complément à 2 reçoit sur un amplificateur inverseur la valeur numérique n issue du registre 7 : la valeur de sortie n̄ issue de l'inverseur 12 est adressée sur une première porte d'un sommateur 13, lequel reçoit également sur une seconde porte une valeur « 1 » numérique. La valeur de sortie n̄ + 1 qui est le complément à 2 nécessaire pour calculer les angles de phase correspondants aux périodes négatives du signal sinusoïdal, est adressée sur une première borne repérée 1 d'un commutateur 14. Ce commutateur 14 reçoit sur une seconde borne repérée 2 le signal n directement prélevé à la sortie du registre 7. Enfin, par une borne 15 le commutateur 14 est piloté par le bit de signe $2^8$, bit dont le poids est selon l'angle de déphasage soit 0 soit 1. Le signal transmis à la sortie du commutateur en fonction de la valeur du bit de signe est rapporté ci-dessous :

| bit de signe $2^8$ : | 0 | 1 |
|---|---|---|
| position du commutateur : | plot 1 | plot 2 |
| valeur transférée par le commutateur : | n̄ + 1 | n |

Le signal transmis par le commutateur 14 est adressé parallèlement aux deux registres 9 et 10 précédemment cités, pilotés sur leurs portes d'horloge par les signaux d'échantillonnage de sinus et de cosinus respectivement, le registre 9 étant affecté à l'enregistrement des sinus, et le registre 10 affecté à l'enregistrement des cosinus.

Sur les bornes de sortie du registre 9, sont disponibles d'une part une information de signe de sinus qui provient directement de l'information du bit de signe $2^8$, et d'autre part 8 bits donnant la valeur absolue de A sin φ. De la même façon, sur les bornes de sortie du registre 10, sont disponibles d'une part le signe du cosinus et d'autre part sur 8 bits la valeur absolue de A cos φ.

Ces valeurs absolues et les signes de sinus et cosinus vont permettre d'élaborer les informations de valeur absolue de tg φ ou cotg φ. Le critère de décision pour que le dispositif utilise soit la tangente soit la cotangente est fait par la comparaison des valeurs absolues des sinus et cosinus comme indiqué ci-dessus. Si |A sin φ| est inférieur à |A cos φ|, le dispositif calcule la tangente. Dans le cas contraire, le dispositif calcule la cotangente. La commutation est faite automatiquement par le résultat d'un comparateur numérique.

Le circuit d'élaboration des valeurs absolues de tg φ ou cotg φ comporte un comparateur 16 qui reçoit sur ses deux bornes d'entrée 17 et 18 les informations issues des registres 9 et 10, c'est-à-dire qu'il reçoit sur sa borne d'entrée 17 l'information A|sin φ|, et sur sa borne 18 l'information A|cos φ|. Simultanément, les informations d'entrée du comparateur 16 sont transmises à deux commutateurs 21 et 22, l'information A|sin φ| présente sur la borne d'entrée 17 du comparateur 16 est transmise à une première borne 3 d'un premier commutateur 21 et à une seconde borne 6 d'un second commutateur 22, tandis que l'information A|cos φ| présente sur la borne d'entrée 18 du comparateur est transmise à une seconde borne 4 du premier commutateur 21 et à une première borne 5 d'un second commutateur 22. Les commutateurs 21 et 22 ont été représentés par le schéma symbolique d'un commutateur électromécanique : en fait, ils font partie des registres 20, qui sont des registres à bascules D à sorties 3 états 8 bits, lesquels fonctionnent en fait comme une série de commutateurs.

Le signal de sortie du comparateur 16, prélevé sur la borne 19 est celui qui correspond à la comparaison entre les valeurs absolues du sinus et du cosinus et donc à la décision de fonctionnement du dispositif en calculant soit la tangente soit la cotangente de l'angle de phase. Ce signal de sortie sur la borne 19 est donc adressé aux registres 20 et c'est lui qui pilote les commutateurs 21 et 22. Si les commutateurs sont sur la position correspondant à leur première borne 3 ou 5, le dispositif calculera cotg φ ; si les commutateurs sont comme représentés sur la figure 6 dans la position qui correspond à leur seconde borne 4 et 6, le dispositif calculera la tg de l'angle de phase.

La décision d'effectuer soit le calcul de tg φ, soit le calcul de cotg φ vient donc de la comparaison des valeurs absolues de A sin φ et A cos φ, le signal représentatif de cette comparaison, issu de la borne 19 du comparateur 16, orientant soit A sin φ sur la borne de sortie 23 du commutateur 21, et simultanément A cos φ sur la borne de sortie 24 du commutateur 22, soit inversement A cos φ sur la borne de sortie 23 du commutateur 21 et A sin φ sur la borne de sortie 24 du commutateur 22.

Cet aiguillage des valeurs de A sin φ et A cos φ est rendu nécessaire par le fait que tg φ et cotg φ ne sont pas calculées en faisant le rapport de A sin φ/A cos φ ou inversement, mais par un multiplicateur numérique soit :

$$|tg\ \phi| = A|sin\ \phi|\ \frac{1}{A|cos\ \phi|}$$

et

$$|cotg\ \phi| = A|cos\ \phi|\ \frac{1}{A|sin\ \phi|}$$

L'inverse des fonctions A sin φ ou A cos φ est obtenu par l'intermédiaire d'une mémoire morte programmable PROM 25 disposée sur le chemin électrique de l'une des deux sorties, tel que par exemple le commutateur 21 sur la figure 6, cette mémoire programmable étant programmée de telle façon qu'elle restitue l'inverse de la valeur qui lui est adressée.

Les signaux issus d'un premier commutateur, le commutateur 21 suivi de la mémoire PROM inverseuse 25 par exemple, et d'un second commutateur, le commutateur 22, sont tous les deux adressés à un circuit multiplicateur 26 qui effectue donc la multiplication selon l'une des deux équations écrites ci-dessus. Si les commutateurs 21 et 22 sont sur les positions correspondantes à leurs bornes 3 et 5, le multiplicateur 26 effectue la multiplication (1/1|sin φ|) (A|cos φ|). Si les commutateurs 21 et 22 sont sur les positions correspondant à leurs bornes 4 et 6, le multiplicateur 26 effectue la multiplication (1/A|cos φ|) (A|sin φ|).

Le signal de sortie du multiplicateur 26, qui est donc la valeur numérique de tg φ, ou de cotg φ est adressé à un accumulateur 27 qui effectue la moyenne sur plusieurs valeurs de tg φ et cotg φ, en vue d'améliorer le raport signal sur bruit de la valeur de sortie.

Les différentes valeurs de tg φ ou cotg φ, de signe des sinus et cosinus et l'information de décision de calcul soit par la tg soit par la cotg qui ont été élaborées jusqu'à présent dans le circuit selon l'invention permettent de calculer l'angle φ.

C'est une mémoire morte programmable PROM 28 qui effectue le calcul. Cette mémoire reçoit sur ses entrées 29 l'information sur 8 bits de tg φ ou cotg φ provenant de l'accumulateur 27 ; elle reçoit également sur son entrée 30 l'information sur 1 bit de décison de calcul soit en tg soit en cotg, cette information provenant de la borne de sortie 19 du comparateur 16 ; elle reçoit enfin sur ses deux entrées 31 et 32 les deux informations de signes de sinus φ et cosinus φ sur 1 bit. Tous les éléments sont donc réunis pour calculer sans équivoque l'angle φ dont la valeur numérique est restituée sur 9 bits sur la borne de sortie 33 de la PROM 28.

Le dispositif de mesure de l'angle de phase entre 2 signaux, un signal sinusoïdal et un signal logique périodique de même fréquence que le signal sinusoïdal, qui a été décrit au titre de l'invention, est notamment appliqué dans la synchronisation de balayage des lignes dans un magnétoscope. Ce dispositif permet de corriger les erreurs de défilement liées aux erreurs de vitesse de la bande, à l'extension ou à la compression de la bande due à la température, à l'humidité ou à tout autre motif.

Cependant, ce dispositif sert de façon plus générale à la synchronisation de tout système dans lequel un signal sinusoïdal doit être bien repéré dans le temps par rapport à des créneaux logiques ou par rapport à des impulsions.

# 0 071 504

## Revendications

1. Dispositif de mesure de l'angle de phase ($\phi$) entre un signal sinusoïdal et un signal logique périodique, de même fréquence (F), comportant sur l'entrée du signal sinusoïdal, un convertisseur analogique-numérique (3) échantillonneur, caractérisé en ce qu'il comprend :
— un circuit multiplicateur de fréquence (5) qui transforme le signal logique périodique de fréquence F en un signal logique périodique de fréquence 4F, servant à échantillonner le convertisseur A-N (3) à raison de deux échantillons par demi période du signal sinusoïdal, ces échantillons étant représentatifs de sin $\phi$ et de cos $\phi$ décalé de $\pi/2$ ;
— un circuit (7, 8, 9, 10, 11) d'extraction à partir des échantillons fournis par le convertisseur A-N(3), des valeurs absolues de A sin $\phi$ et A cos $\phi$, A étant l'amplitude du signal sinusoïdal, ainsi que les signes de sin $\phi$ et de cos $\phi$ ;
— un circuit de calcul (16, 20, 25, 26) de la valeur absolue de tg $\phi$ ou de cotg $\phi$, à partir des valeurs absolues de A sin $\phi$ et de A cos $\phi$, selon que A sin $\phi <$ A cos $\phi$ ou que A sin $\phi >$ A cos $\phi$ ;
— un accumulateur (27) qui stocke une pluralité d'informations |tg $\phi$| ou |cotg $\phi$| et en restitue une valeur moyenne ;
— une mémoire programmable (28) qui reçoit sur ses entrées les informations numériques représentatives de |tg $\phi$| ou |cotg $\phi$|, de l'opération effectuée soit en |tg $\phi$| soit en |cotg $\phi$| (30), du signe de cos $\phi$ (31) et du signe de sin $\phi$ (32) , et qui délivre sur ses sorties (33) une information numérique représentative de l'angle de phase $\phi$.

2. Dispositif de mesure de l'angle de phase selon la revendication 1, caractérisé en ce que, le convertisseur A-N(3) étant à $2^n$ bits, les bits compris entre $2^0$ et $2^{n-1}$ fournissent une valeur numérique représentative de sin $\phi$ et de cos $\phi$, et de bit de fort poids $2^n$ fournit le signe du sinus et du cosinus, sous forme d'un 0 ou d'un 1 logique.

3. Dispositif de mesure de l'angle de phase selon la revendication 2, caractérisé en ce que le circuit d'extraction des valeurs absolues de A sin $\phi$ et A cos $\phi$ comporte :
— un premier registre (7) qui reçoit sur ses entrées les valeurs numériques issues du convertiseur (3), ainsi qu'une information d'échantillonnage issue d'un circuit de prélèvement (8) de signaux correspondant à la mesure de sin $\phi$ et de cos $\phi$ dans le signal logique à fréquence 4 F, le registre délivrant sur ses sorties, d'une part, la valeur numérique de fort poids représentant le signe de sin $\phi$ et de cos $\phi$, d'autre part les valeurs numériques de mesure ;
— un circuit (11) de complément à 2 pour les valeurs numériques pour lesquelles le signe est négatif, ce circuit (11) comportant un inverseur (12) suivi d'un sommateur (13) complémenté à 1, et un commutateur (14) commandé par l'information de signe (15) issue du registre (7), le commutateur délivrant sur sa borne de sortie les valeurs numériques issues du registre (7) lorsque l'information de signe est un 1 logique, et les valeurs complémentées à 2 lorsque l'information de signe est un 0 logique ;
— un second registre (9), qui reçoit sur ses entrées l'information de signe issue du premier registre (7) ainsi que les valeurs numériques issues du commutateur (14) et qui délivre sur ses sorties la valeur absolue de A sin $\phi$, sous forme numérique, ainsi que le signe ;
— un troisième registre (10) qui reçoit sur ses entrées l'information de signe issue du premier registre (7) ainsi que les valeurs numériques issues du commutateur (14) et qui délivre sur ses sorties la valeur absolue de A cos $\phi$, sous forme numérique, ainsi que le signe.

4. Dispositif de mesure de l'angle de phase selon la revendication 2, caractérisé en ce que le circuit de calcul des valeurs absolues de |tg $\phi$| et |cotg $\phi$| comporte :
— un comparateur (16) qui reçoit sur ses entrées (17,18) les valeurs numériques représentatives de A|sin $\phi$| et de A|cos $\phi$|, les compare et délivre sur sa sortie (19) une information de calcul de |tg $\phi$| ou |cotg $\phi$| ;
— un registre (20) de bascules D, chacune des bascules (21, 22) recevant sur une première borne d'entrée, la valeur numérique de A|sin $\phi$| et sur une seconde borne d'entrée la valeur numérique de A|cos $\phi$| et délivrant sur sa borne de sortie (23, 24), soit A|sin $\phi$| soit A|cos $\phi$| selon l'information de comparaison issue de la sortie (19) du comparateur (16) ;
— une mémoire programmable (25) recevant sur son entrée les informations issues d'une première sortie (23) du registre (20) et délivrant sur sa sortie l'inverse de ces dites informations ;
— un circuit multiplieur (26), qui reçoit sur une première entrée les valeurs issues de la mémoire programmable (25) (1/A|sin $\phi$| ou 1/A|cos $\phi$|) sur une seconde entrée les valeurs issues d'une seconde sortie (24) du registre (20) (A|cos $\phi$| ou A|sin $\phi$|) et en effectue la multiplication en vue de délivrer sur sa sortie soit |tg $\phi$| soit |cotg $\phi$| ;
— un accumulateur (27), qui reçoit les valeurs issues du multiplieur (26) et délivre sur sa sortie une valeur moyennée de |tg $\phi$| ou de |cotg $\phi$|.

## Claims

1. A device for measuring the phase angle ($\phi$) between a sine wave signal and a cyclic logic signal of

7

the same frequency (F) comprising, on the input of the sine wave signal, an analog-digital sampler-converter (3), characterized in that it comprises :

— a frequency multiplying circuit (5), which transforms the cyclic logic signal of frequency F into a cyclic logic signal of frequency 4 F for the purpose of sampling the A-D converter (3) at a rate of 2 samples per half-cycle of the sine wave signal, said samples being representative of sin $\phi$ and cos $\phi$ delayed by $\pi/2$,

— a circuit (7, 8, 9, 10, 11) for extracting from the samples supplied by the A-D converter (3), absolute values of A sin $\phi$ and A cos $\phi$, A being the amplitude of the sine wave signal, as well as the signs of sin $\phi$ and cos $\phi$,

— a circuit (16, 20, 25, 26) for calculating the absolute value of tg $\phi$ or cotg $\phi$ on the basis of the absolute values of A sin $\phi$ and A cos $\phi$, depending on whether A sin $\phi$ < A cos $\phi$ or A sin $\phi$ > A cos $\phi$,

— an accumulator (27) which stores a plurality of informations |tg $\phi$| or |cotg $\phi$| and restores a mean value therefrom,

— a programmable memory (28) receiving on its inputs the digital informations representing |tg $\phi$| or |cotg $\phi$|, from the operation performed either in |tg $\phi$| or |cotg $\phi$|, of the sign of cos $\phi$ (31) and the sign of sin $\phi$ (32), and which supplies at its outputs (33) a digital information representing the phase angle $\phi$.

2. A phase angle measuring device according to claim 1, characterized in that the A-D converter (3) has $2^n$ bits, and the bits between $2^0$ and $2^{n-1}$ supply a digital value representing sin $\phi$ and cos $\phi$, the most significant bit $2^n$ supplying the sign of the sine and the cosine in the form of a logic 0 or a logic 1.

3. A phase angle measuring device according to claim 2, characterized in that the circuit for extracting absolute values of A cos $\phi$ and A sin $\phi$ comprises :

— a first register (7) receiving at its inputs the digital values coming from the converter (3), as well as sampling informations coming from a circuit (8) for sampling signals corresponding to the measurement of sin $\phi$ and cos $\phi$ in the logic signal at frequency 4 F, the register supplying at its outputs on the one hand the most significant digital value representing the sign of sin $\phi$ and cos $\phi$ and on the other hand the digital measuring values,

— a twos-complements circuit (11) für the digital values for which the sign is negative, said circuit (11) comprising an inverter (12) followed by a ones-complement adder (13) and a switch (14) controlled by the sign information (15) from the register (7), the switch supplying at its output terminal the digital values from the register (7) when the sign information is logic 1, and twos-complement values when the sign information is a logic 0,

— a second register (9) receiving at its inputs the sign information from the first register (7), as well as the digital values from the switch (14) and which supplies at its terminals the absolute value of A sin $\phi$ in digital form, as well as the sign,

— a third register (10) receiving at its inputs the sign information from the first register (7), as well as digital values from the switch (14) and supplying at its ouputs the absolute value of A cos $\phi$, in digital form, as well as the sign.

4. A phase angle measuring device according to claim 2, characterized in that the circuit for calculating the absolute values of |tg $\phi$| and |cotg $\phi$| comprises :

— a comparator (16) receiving at its inputs (17, 18) the digital values representing A|sing $\phi$| and A|cos $\phi$|, compares them and supplies at its output (19) |tg $\phi$ or |cotg $\phi$| calculation information,

— a D-flip-flop register (20), each of the flip-flops (21, 22) receiving at a first input terminal the digital value of A|sin $\phi$| and at a second input terminal the digital value of A|cos $\phi$| and supplying at its output terminal (23, 24) either A|sin $\phi$| or A |cos $\phi$|, depending on the comparison information from the output (19) of the comparator (16),

— a programmable memory (25) receiving at its input the informations from the first output (23) of the register (20) and supplying at its output the reciprocal of said informations,

— a multiplying circuit (26) receiving at a first input the values from the programmable memory (25) (1/A|sin $\phi$| or 1/A|cos $\phi$|) and at a second input the values from a second output (24) of the register (20) (A|cos $\phi$| or A |sin $\phi$|) and carries out the multiplication thereof in order to supply at its output either |tg $\phi$| or |cotg $\phi$|,

— an accumulator (27) receiving the values from the multiplier (26) and supplying at its output a mean value of |tg $\phi$| or |cotg $\phi$|.

**Patentansprüche**

1. Vorrichtung zum Messen des Phasenwinkels ($\phi$) zwischen einem sinusförmigen Signal und einem periodischen logischen Signal der gleichen Frequenz (F), die am Eingang für das sinusförmige Signal einen Analog-Digital-Wandler-Taster (3) aufweist, dadurch gekennzeichnet, daß sie aufweist :

— einen Frequenzmultiplikationskreis (5), der das periodische logische Signal der Frequenz F in ein periodisches logisches Signal der Frequenz 4F umwandelt, das dazu dient, den AD-Wandler (3) so zu tasten, daß er zwei Tastproben pro Halbperiode des sinusförmigen Signals liefert wobei diese Tastproben repräsentativ für sin Q $\phi$ und cos $\phi$, verschoben um $\pi/2$, sind,

— einen Kreis (7, 8, 9, 10, 11) zur Entnahme der ausgehend von den vom AD-Wandler (3) gelieferten Tastproben die Absolutwerte von A sin $\phi$ und A cos $\phi$, wobei A die Amplitude des sinusförmigen Signals ist, sowie die Vorzeichen von sin $\phi$ und cos $\phi$ liefert,

— einen Kreis (16, 20, 25, 26) zur Berechnung des Absolutwerts von tg $\phi$ oder des cot $\phi$, ausgehend von den Absolutwerten von A sin $\phi$ und A cos $\phi$, je nachdem, ob A sin $\phi <$ A cos $\phi$ oder ob A sin $\phi >$ A cos $\phi$ ist,

— einen Akkumulator (27), der eine Vielzahl von Informationen |tg $\phi$| oder |cot $\phi$| speichert und daraus einen mittleren Wert erstellt,

— einen programmierbaren Speicher (28), der an seinen Eingängen die digitalen Informationen empfängt, die für |tg $\phi$| oder |cot $\phi$|, für die entweder in |tg $\phi$| oder in |cot $\phi$| ausgeführte Operation (30), für das Vorzeichen von cos $\phi$ (31) und das Vorzeichen von sin $\phi$ (32) repräsentativ sind, und der an seinen Ausgängen (33) eine digitale Information liefert, die für den Phasenwinkel $\phi$ repräsentativ ist.

2. Vorrichtung zum Messen des Phasenwinkels nach Anspruch 1, dadurch gekennzeichnet, daß der AD-Wandler (3) $2^n$ Bits hat und zwischen $2^0$ und $2^{n-1}$ gewichtete Bits einen digitalen Wert liefern, der repräsentativ für sin $\phi$ und cos $\phi$ ist, und daß das höchstwertige Bit $2^n$ das Vorzeichen des Sinus und des Cosinus in Form einer logischen 0 oder 1 liefert.

3. Vorrichtung zum Messen des Phasenwinkels nach Anspruch 2, dadurch gekennzeichnet, daß der Kreis zur Entnahme der Absolutwerte von A sin $\phi$ und A cos $\phi$ aufweist :

— ein erstes Register (7), das an seinen Eingängen die aus dem Wandler (3) stammenden digitalen Werte sowie eine Tastungs-information zugeführt erhält, die aus einem Krei (8) zur Entnahme von Signalen stammt, welche dem Wert von sin $\phi$ und cos $\phi$ im logischen Signal der Frequenz 4F entsprechen, wobei das Register an seinen Ausgängen einerseits den digitalen Wert des höchstwertigen Bits, der das Vorzeichen von sin $\phi$ und cos $\phi$ repräsentiert, und andererseits die digitalen Meßwerte liefert,

— einen Kreis (11) zur Zweierkomplementierung für die digitalen Werte, für die das Vorzeichen negativ ist, wobei dieser Kreis (11) einen von einem zu 1 komplementierten Summierer (13) gefolgten Inverter (12) und einen Schalter (14) aufweist, der von der vom Register (7) ausgegebenen Vorzeicheninformation (15) gesteuert wird, wobei der Schalter an seiner Ausgangsklemme die vom Register (7) stammenden digitalen Werte liefert, wenn die Vorzeicheninformation eine logische 1 ist, bzw. die zu 2 komplementierten Werte, wenn die Vorzeicheninformation eine logische 0 ist,

— ein zweites Register (9), das an seinen Eingängen die vom ersten Register (7) stammende Vorzeicheninformation sowie die vom Schalter (14) stammenden digitalen Werte zugeführt erhält und das an seinen Ausgängen den Absolutwert von A sin $\phi$ in digitaler Form sowie das Vorzeichen liefert,

— ein drittes Register (10), das an seinen Eingängen die vom ersten Register (7) stammende Vorzeicheninformation sowie die vom Schalter (14) stammenden digitalen Werte empfängt und das an seinen Ausgängen den Absolutwert von A cos $\phi$ in digitaler Form sowie das Vorzeichen liefert.

4. Vorrichtung zum Messen des Phasenwinkels nach Anspruch 2, dadurch gekennzeichnet, daß der Kreis zum Berechnen der Absolutwerte von |tg $\phi$| und |cot $\phi$| aufweist :

— einen Komparator (16), der an seinen Eingängen (17, 18) die für A sin $\phi$ und A cos $\phi$ repräsentativen digitalen Werte zugeführt erhält, sie vergleicht und an seinem Ausgang (19) eine Information der Berechnung von |tg $\phi$| oder |cot $\phi$| liefert,

— ein aus D-Kippstufen bestehendes Register (20), wobei jede der Kippstufen (21, 22) an einer ersten Eingangsklemme den digitalen Werte von A|sin $\phi$| und an einer zweiten Eingangs-klemme den digitalen Wert von A|cos $\phi$| empfängt und an ihrer Ausgangsklemme (23, 24) entweder A |sin $\phi$| oder A|cos $\phi$| liefert, je nach der vom Ausgang (19) des Komparators (16) stammenden Vergleichsinformation,

— einen programmierbaren Speicher (25), der an seinem Eingang die von einem ersten Ausgang (23) des Registers (20) stammenden Informationen empfängt und an seinem Ausgang die Umkehrung dieser Informationen liefert,

— einen Multiplizierkreis (26), der an einem ersten Eingang die vom programmierbaren Speicher (25) stammenden Werte (1/A|sin $\phi$| oder 1/A |cos $\phi$| und an einem zweiten Eingang die von einem zweiten Ausgang (24) des Registers (20) stammenden Werte (A|cos $\phi$| oder A |sin $\phi$|) empfängt und deren Multiplikation durchführt, um an seinem Ausgang entweder |tg $\phi$| oder |cot $\phi$| zu liefern,

— einen Akkumulator (27), der die vom Multiplizierer (26) stammenden Werte empfängt und an seinem Ausgang einen Mittel-wert von |tg $\phi$| oder von |cot $\phi$| liefert.

# FIG.1

# FIG.2

# FIG.3

# FIG.4

# FIG.5

FIG.6